# EUROPÄISCHE PATENTSCHRIFT

(11) **EP 1 750 373 B1**
(45) Veröffentlichungstag und Bekanntmachung des Hinweises auf die Patenterteilung: **17.09.2008**
(21) Anmeldenummer: 06014310.4
(22) Anmeldetag: 11.07.2006
(51) Int. Cl.: H03K 17/96

(54) **Kraftfahrzeug mit einer Schaltvorrichtung**
Vehicle with a switching device
Véhicule avec un dispositif de commutation

(30) Priorität: 02.08.2005 DE 102005036218
(43) Veröffentlichungstag der Anmeldung: 07.02.2007
(73) Patentinhaber: Bayerische Motoren Werke Aktiengesellschaft, 80809 München (DE)
(72) Erfinder: Schröter, Gunter, 80809 München (DE); Heydenreich, Bertram, 85579 Neubiberg (DE)

(56) Entgegenhaltungen:
- EP-A2- 0 417 048
- DE-A1- 10 126 670

## Beschreibung

Die Erfindung betrifft ein Kraftfahrzeug mit einer Schaltvorrichtung nach dem Oberbegriff des Patentanspruchs 1.

Aus der EP 0 417 048 A2 ist eine Schaltvorrichtung bekannt, die an einer Außenwand von Fahrzeugen aller Art zum Öffnen der Türen dient. Die Schaltvorrichtung weist ein Gehäuse mit einer Tastfläche zur Betätigung auf. Im Gehäuse-Innenraum ist ein piezoelektrischer Wandler angeordnet. Wenn eine Person mit einem Finger auf die Tastfläche drückt, erzeugt der Wandler ein elektrisches Signal und führt dieses elektronischen Schaltungsmitteln zu.

Die DE 101 26 670 A offenbart den Oberbegriff des Anspruchs 1.

Aufgabe der Erfindung ist es, ein Kraftfahrzeug mit einer Schaltvorrichtung zu schaffen, die das optische Erscheinungsbild des Kraftfahrzeugs möglichst wenig beeinträchtigt.

Diese Aufgabe wird mit einem Kraftfahrzeug mit einer Schaltvorrichtung mit den Merkmalen des Patentanspruchs 1 gelöst.

Erfindungsgemäß weist ein Kraftfahrzeug an der Fahrzeugaußenseite eine Schaltvorrichtung mit einem piezoelektrischen Wandler hinter einer Tastfläche auf. Die Tastfläche wird gebildet durch einen Bereich einer Fensterscheibe oder eines Karosserieaußenhautbauteils, sodass die Schaltvorrichtung von der Fahrzeugaußenseite nicht sichtbar oder nur durch die Fensterscheibe hindurch sichtbar ist. Zum Betätigen der Schaltvorrichtung muss die Tastfläche geringfügig elastisch verformt werden. Dazu reicht es aus, mit einem Finger mit nur geringer Kraft gegen die Fensterscheibe oder das Karosserieaußenhautbauteil im Bereich der Schaltvorrichtung zu drücken, da der piezoelektrische Wandler bereits kleinste Verformungen registrieren kann. Der vom piezoelektrischen Wandler ausgenutzte piezoelektrische Effekt kann beispielsweise von einem Bauteil aus einem piezokeramischen Werkstoff oder aber auch aus einem Polymer mit piezoelektrischen Eigenschaften, wie beispielsweise Polyvinylidenfluorid PVDF, stammen.

Vorteilhafterweise dient die Schaltvorrichtung dazu, ein Schloss einer Kraftfahrzeugtür und / oder -klappe zu entriegeln. Dies setzt eine elektrisch entriegelbare Verriegelungseinrichtung für die Kraftfahrzeugtür und / oder -klappe voraus. Durch den Einsatz der Schaltvorrichtung kann ein konventioneller Türöffner entfallen. Das optische Erscheinungsbild des Kraftfahrzeugs von außen wird also weder durch einen Türaußengriff noch durch eine optisch auffallende Schaltvorrichtung beeinträchtigt. Zudem ist der piezoelektrische Wandler vor Verschmutzungen geschützt, und es gibt im Gegensatz zu einem Türgriff oder zu einem konventionellen elektrischen Schalter keine zueinander verschwenkbaren oder verschiebbaren Bauteile, die zur Fahrzeugaußenseite hin gegen Schmutz und Feuchtigkeit abgedichtet werden müssen.

Der piezoelektrische Wandler ist direkt auf der Innenseite der Fensterscheibe oder des Karosserieaußenhautbauteils angebracht. Dazu kann der piezo-elektrische Wandler günstigerweise auf der Innenseite der Fensterscheibe oder des Karosserieaußenhautbauteils aufgeklebt oder bei einem Karosserieaußenhautbauteil aus Kunststoff auch eingespritzt sein.

Die Fraunhofer-Gesellschaft entwickelt seit einigen Jahren Piezofaser-Funktionswerkstoffe. Dazu sind auch einige Informationen im Internet unter http://www.smart-materials.fhg.de erhältlich. Idealerweise ist der elektrische Wandler durch ein Bauteil aus einem Piezofaser-Funktionswerkstoff gebildet. Dadurch kann das Bauteil sogar einteilig mit dem Karosserieaußenhautbauteil ausgeführt sein, in das zumindest in einem Bereich Piezofasern integriert sind.

Weitere vorteilhafte Ausgestaltungen sind Gegenstand von Unteransprüchen.

In der Zeichnung ist ein Ausführungsbeispiel der Erfindung dargestellt, anhand dessen die Erfindung im folgenden näher beschrieben wird. Die einzelnen Figuren zeigen in schematischer Darstellungsweise:
- Fig. 1: eine Heckklappe eines Personenkraftwagens der Kombinationsbauart,
- Fig. 2: einen Schnitt durch die Heckklappe aus Fig. 1 im Bereich einer Heckscheibe und,
- Fig. 3: einen Schnitt durch die Heckklappe aus Fig. 1 im Bereich unterhalb der Heckscheibe.

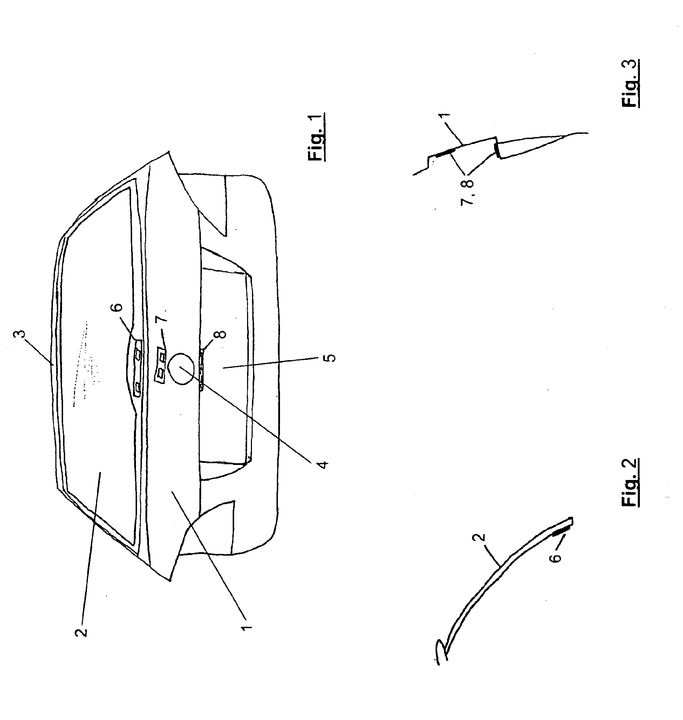

In Fig. 1 ist eine Heckklappe 1 eines Personenkraftwagens der Kombinationsbauart dargestellt. Die Heckklappe 1 ist an ihrem oberen Rand an eine Fahrzeugkarosserie des Personenkraftwagens angelenkt. Im oberen Bereich weist die Heckklappe 1 einen großen rahmenartigen Ausschnitt auf, in dem sich eine Heckscheibe 2 befindet. Die Heckscheibe 2 ist oben über zwei Scharniere an einem Querträger 3 angelenkt, der die obere Begrenzung des Ausschnitts bildet. Unterhalb der Heckscheibe 2 ist mittig auf der Heckklappe 1 ein Markenemblem 4 angebracht, unter dem sich wiederum ein Bereich 5 zum Anbringen eines Nummernschildes anschließt.

Zum Beladen des mit der Heckklappe 1 verschließbaren Laderaums des Personenkraftwagens kann entweder nur die Heckscheibe 2 oder die gesamte Heckklappe 1 mit der Heckscheibe 2 nach oben verschwenkt werden. Sowohl die Heckklappe 1 als auch die Heckscheibe 2 werden jeweils in ihrer geschlossenen Stellung durch ein elektrisch betätigbares Schloss gehalten, damit sich weder die Heckscheibe 2 noch die Heckklappe 1 ungewollt öffnen kann. Die beiden Schlösser sind mit einem Steuergerät verbunden, das die Schlösser öffnet, wenn ein entsprechendes Steuersignal vorliegt. Das Steuersignal zum Öffnen der Heckklappe 1 wird erzeugt, wenn eine Schaltvorrichtung 6 betätigt wird, die mittig im unteren Bereich der Heckscheibe 2 angeordnet ist. Um ein unbeabsichtigtes Öffnen der Heckklappe 1 zu vermeiden, könnten alternativ auch zwei Schaltvorrichtungen 6 vorgesehen werden, die dann zum Öffnen der Heckklappe 1 gleichzeitig betätigt werden müssen. Zur Verdeutlichung der Position ist die eine Schaltvorrichtung 6 in Fig. 1 eingezeichnet, obwohl sie in Wirklichkeit nicht sichtbar ist. In Fig. 2 ist die tatsächliche Anordnung der Schaltvorrichtung 6 im Schnitt gut erkennbar.

Die Schaltvorrichtung 6 weist als eigentlichen Sensor ein kleines flächiges Bauteil aus einem piezoelektrischen Funktionswerkstoff auf, das direkt auf der Innenseite der Heckscheibe 2 aufgeklebt ist. Dieses flächige Bauteil erzeugt aufgrund der integrierten Piezofasern bereits bei kleinsten Verformungen elektrische Signale, die von einem Signalprozessor in ein Steuersignal für das Steuergerät umgewandelt werden können. Wenn nun jemand leicht von außen gegen die Heckscheibe 2 im Bereich der Schaltvorrichtung 6 drückt, biegt sich die Heckscheibe 2 geringfügig elastisch durch. Da die Schaltvorrichtung 6 direkt mit der Heckscheibe 6 verklebt ist, verformt sich dabei auch das als Sensor dienende kleine flächige Bauteil aus dem piezoelektrischen Funktionswerkstoff. Dadurch entsteht ein elektrisches Signal, das von dem Signalprozessor in ein Steuersignal für das Steuergerät umgewandelt wird. Das Steuergerät wiederum steuert das elektrische Schloss an, sodass dieses sich öffnet und die Heckscheibe 2 geöffnet werden kann.

Der große Vorteil einer solchen Schaltvorrichtung 6 liegt darin, dass das optische Erscheinungsbild durch keinen Schalter oder Tür- bzw. Klappenöffner beeinträchtigt wird. Zudem muss kein Schalter oder sonstiges mechanisch verlagerbares Bauteil gegenüber der Umgebung gegen Verschmutzung und Spritzwasser geschützt werden. Damit der Bediener der Schaltvorrichtung 6 weiß, welchen Bereich der Heckscheibe 2 er zum Betätigen der Schaltvorrichtung 6 zum Öffnen der Heckscheibe 2 drücken muss, kann die Heckscheibe 2 in dem Bereich der Schaltvorrichtung einen farbigen Aufdruck oder eine sonstige farbliche Kennzeichnung aufweisen, die den Benutzer auf den richtigen Bereich hinweist. Der von der Schaltvorrichtung 6 benötigte Bauraum ist zudem wesentlich geringer, als dies bei konventionellen elektrischen Schaltern der Fall ist.

Zum Öffnen des elektrischen Schlosses der Heckklappe 1 sind zwei Schaltvorrichtungen 7 und 8 vorgesehen. Die erste Schaltvorrichtung 7 befindet sich mittig oberhalb des Markenemblems 4, die zweite Schaltvorrichtung befindet sich im Vorsprung der Heckklappe 1 oberhalb des Bereichs 5 zum Anbringen eines Nummernschildes. Die Schaltvorrichtungen 7 und 8 sind zur Verdeutlichung ihrer jeweiligen Position in Fig. 1 dargestellt, obwohl sie in Wirklichkeit von außen nicht sichtbar sind. In Fig. 3 ist zur Verdeutlichung ein Schnitt durch den entsprechenden Bereich der Heckklappe 1 dargestellt. Beide Schaltvorrichtungen 7 und 8 weisen wie bereits bei der Schaltvorrichtung 6 als eigentlichen Sensor jeweils ein kleines flächiges Bauteil aus einem piezoelektrischen Funktionswerkstoff auf, das jeweils direkt auf der Innenseite des Außenblechs der Heckklappe 1 verklebt ist. Wenn nun jemand leicht von außen gegen das Außenblech der Heckklappe 1 im Bereich einer der Schaltvorrichtungen 7, 8 drückt, biegt sich das Außenblech geringfügig elastisch durch. Da die Schaltvorrichtungen 7, 8 direkt mit dem Außenblech 6 verklebt sind, verformt sich dabei auch das als Sensor dienende kleine flächige Bauteil aus dem piezoelektrischen Funktionswerkstoff. Dadurch entsteht ein elektrisches Signal, das von einem Signalprozessor in ein Steuersignal für das Steuergerät umgewandelt wird. Das Steuergerät wiederum steuert das elektrische Schloss an, sodass dieses sich öffnet und die Heckklappe 1 geöffnet werden kann.

Der wesentliche Vorteil ist analog zu der Schaltvorrichtung 6 hinter der Heckscheibe 2, dass die Schaltvorrichtungen 7 und 8 am Personenkraftwagen nicht sichtbar sind und keiner Verschmutzung und keinem Spritzwasser ausgesetzt sind.

## Patentansprüche

1. Kraftfahrzeug mit einer Schaltvorrichtung (6, 7, 8) an der Fahrzeugaußenseite, wobei die Schaltvorrichtung (6, 7, 8) einen piezoelektrischen Wandler hinter einer Tastfläche aufweist, **dadurch gekennzeichnet, dass** die Tastfläche gebildet wird durch einen Bereich einer Fensterscheibe (2) oder eines Karosserieaußenhautbauteils (1), sodass die Schaltvorrichtung (6, 7, 8) von der Fahrzeugaußenseite nicht sichtbar oder nur durch die Fensterscheibe (2) hindurch sichtbar ist, wobei der piezoelektrische Wandler direkt auf der Innenseite der Fensterscheibe (2) oder des Karosserieaußenhautbauteils (1) angebracht ist.

2. Kraftfahrzeug nach Anspruch 1, **dadurch gekennzeichnet, dass** zur Betätigung der Schaltvorrichtung (6, 7, 8) die Tastfläche geringfügig elastisch verformt wird.

3. Kraftfahrzeug nach Anspruch 1 oder 2, **dadurch gekennzeichnet, dass** der piezoelektrische Wandler auf der Innenseite der Fensterscheibe (2) oder des Karosserieaußenhautbauteils (1) aufgeklebt oder bei einem Karosserieaußenhautbauteil aus Kunststoff eingespritzt ist.

4. Kraftfahrzeug nach einem der vorhergehenden Ansprüche, **dadurch gekennzeichnet, dass** der elektrische Wandler durch ein Bauteil aus einem Piezofaser-Funktionswerkstoff gebildet ist.

5. Kraftfahrzeug nach Anspruch 4, **dadurch gekennzeichnet, dass** das Bauteil das Karosserieaußenhautbauteil ist, in das zumindest in einem Bereich Piezofasern integriert sind.

6. Kraftfahrzeug nach einem der vorhergehenden Ansprüche, **dadurch gekennzeichnet, dass** bei Betätigung der Schaltvorrichtung (6, 7, 8) ein Schloss einer Kraftfahrzeugtür und / oder -klappe entriegelt wird.

## Claims

1. A motor vehicle with a switching device (6, 7, 8) on the outside of the vehicle, wherein the switching device (6, 7, 8) comprises a piezoelectric transducer behind a touch surface, **characterised in that** the touch surface is a region of a window (2) or of a skin component (1), so that the switching device (6, 7, 8) is invisible from the outside of the vehicle or is visible only through the window (2), wherein the piezoelectric transducer is directly mounted on the inside of the window (2) or of the skin component (1).

2. A motor vehicle according to claim 1, **characterised in that** the touch surface is slightly deformed elastically in order to actuate the switching device (6, 7, 8).

3. A motor vehicle according to claim 1 or claim 2, **characterised in that** the piezoelectric transducer is stuck to the inside of the window (2) or of the skin component (1) or is injection moulded in the case when the skin component is of plastics material.

4. A motor vehicle according to any of the preceding claims, **characterised in that** the electric transducer is a component of a piezo fibre operating material.

5. A motor vehicle according to claim 4, **characterised in that** the component is the skin component in which piezo fibres are incorporated, in at least one region.

6. A motor vehicle according to any of the preceding claims, **characterised in that** a lock on a vehicle door and/or bonnet or tailgate is released when the switching device (6, 7, 8) is actuated.

## Revendications

1. Véhicule comportant un dispositif de commutation (6, 7, 8) sur le côté extérieur du véhicule,
le dispositif de commutation (6, 7, 8) comportant un convertisseur piézoélectrique derrière une surface tactile,
**caractérisé en ce que**
la surface tactile est formée par une zone d'une vitre de fenêtre (2) ou d'un composant de l'enveloppe extérieure de la carrosserie de sorte que le dispositif de commutation (6, 8, 8) n'est pas visible du côté extérieur du véhicule ou n'est visible qu'à travers la vitre (2) de la fenêtre,
le convertisseur piézoélectrique étant appliqué directement sur le côté intérieur de la vitre (2) ou du composant de l'enveloppe extérieure de carrosserie (1).

2. Véhicule automobile selon la revendication 1,
**caractérisé en ce que**
la surface tactile est légèrement déformable élastiquement pour actionner le dispositif de commutation (6, 7, 8).

3. Véhicule automobile selon la revendication 1 ou 2,
**caractérisé en ce que**
le convertisseur piézoélectrique est collé sur le côté intérieur de la vitre de fenêtre (2) ou du composant de l'enveloppe extérieure de carrosserie (1) ou est surmoulé par injection de matière plastique dans le cas d'un composant de l'enveloppe extérieure de carrosserie.

4. Véhicule automobile selon l'une des revendications précédentes,
**caractérisé en ce que**
le convertisseur électrique est formé par un composant en une matière à fonction de fibres piézoélectriques.

5. Véhicule automobile selon la revendication 4,
**caractérisé en ce que**
le composant est le composant de l'enveloppe extérieure de carrosserie dans lequel des fibres piézoélectriques sont intégrées au moins dans une zone.

6. Véhicule selon l'une des revendications précédentes,
**caractérisé en ce que**
l'actionnement du dispositif de commutation (6, 7, 8) déverrouille une serrure de portière de véhicule et/ ou de volet.
